# EUROPEAN PATENT APPLICATION

(11) **EP 1 384 796 A2**
(43) Date of publication of application: **28.01.2004**
(21) Application number: 03016433.9
(22) Date of filing: 21.07.2003
(51) Int. Cl.: C23C 14/24, C23C 14/12, H05B 33/10

(54) **Organic film formation apparatus**

(30) Priority: 22.07.2002 JP 2002213004
(71) Applicant: SONY CORPORATION, Tokyo (JP)
(72) Inventor: Sasaki, Koji, Shinagawa-ku, Tokyo (JP); Narui, Hironobu, Shinagawa-ku, Tokyo (JP); Yanashima, Katsunori, Shinagawa-ku, Tokyo (JP); Tanaka, Sadao, Shinagawa-ku, Tokyo (JP); Memezawa, Akihiko, Shinagawa-ku, Tokyo (JP)
(74) Representative: Müller - Hoffmann & Partner

(57) **Abstract**

The organic raw material is vaporized to generate the raw material gas in the vaporizing chamber. This raw material gas is mixed with the carrier gas, and transported to the chamber through the raw material gas transportation pipe. The substrate is held within the chamber while the organic film formation surface of the substrate does not face downward in a vertical direction straight up from the ground. The injector of the raw material gas is opposed to the substrate. The raw material gas is blasted from the direction orthogonal to the substrate. Particles fall without adhering to the substrate when holding the substrate in the vertical direction. The deformation of the substrate and the mask for separately painting pixels can be suppressed.

## Description

### BACKGROUND OF THE INVENTION

### 1. Field of the Invention

The present invention relates to an organic film formation apparatus for forming an organic thin film. It particularly relates to an organic film formation apparatus for forming an organic thin film with raw material gas that organic raw material has been vaporized into gas phase being transported onto a substrate with carrier gas.

### 2. Description of Related Art

An organic EL (electroluminescence) device is a light-emitting material in which an organic matter is utilized for a light-emitting layer. This organic EL device is used for a light-emitting material constituting a variety of display devices such as a flat panel display used in a computer or television receiver, a display of a portable telephone, a display of a portable terminal, which is referred to as a PDA (Personal Digital Assistant), and the like. It is also used for a light-emitting element such as a light-emitting diode and the like.

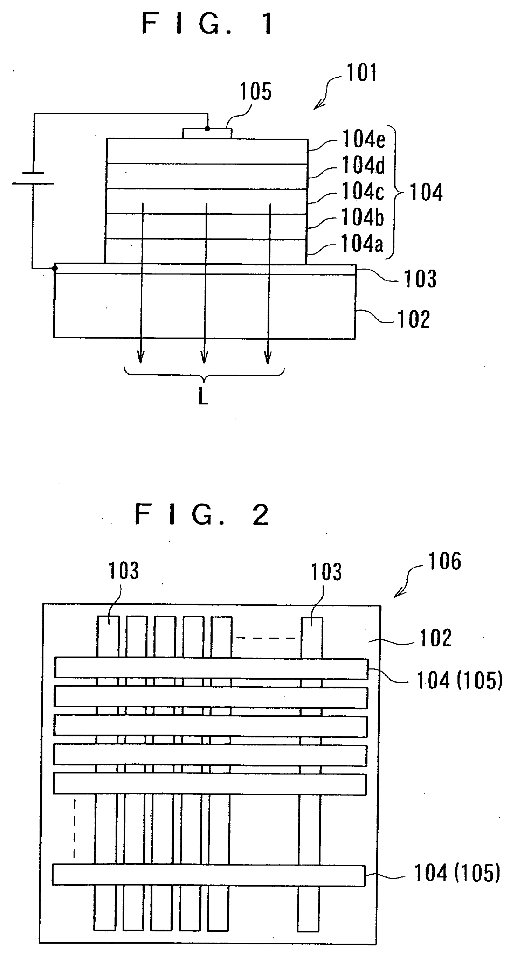

Fig. 1 is an illustration showing an example of a structure of such an organic EL device 101. The organic EL device 101 comprises a transparent substrate 102 such as glass, an ITO (Indium-Tin Oxide) transparent electrode 103, which is an anode, on the transparent substrate 102, an organic film 104,and a back plate electrode 105, which is a cathode. These layers are in turn laminated. The organic film 104 is a layer in which a hole injection layer 104a, a hole transportation layer 104b, a light-emitting layer 104c, an electron transportation layer 104d, and an electron injection layer 104e are in turn laminated from the side of the ITO transparent electrode 103.

When a voltage is applied across the ITO transparent electrode 103 and the back plate electrode 105, positive charges (holes) are injected from the ITO transparent electrode 103; negative charges (electrons) are injected from the back plate electrode 105; and the respective charges move through the organic film 104. Then, within the light-emitting layer 104c, the electrons and the holes are recombined at a certain probability, and when the recombination is performed, a light L having a predetermined wavelength may be generated.

Note that as a configuration of the organic film 104, there are a configuration of one layer consisting of the hole injection layer 104a and the hole transportation layer 104b, a configuration of one layer consisting of the electron transportation layer 104d and the electron injection layer 104e, and a configuration of one layer consisting of the light emitting layer 104c, the electron transportation layer 104d, and the electron injection layer 104e, and the like.

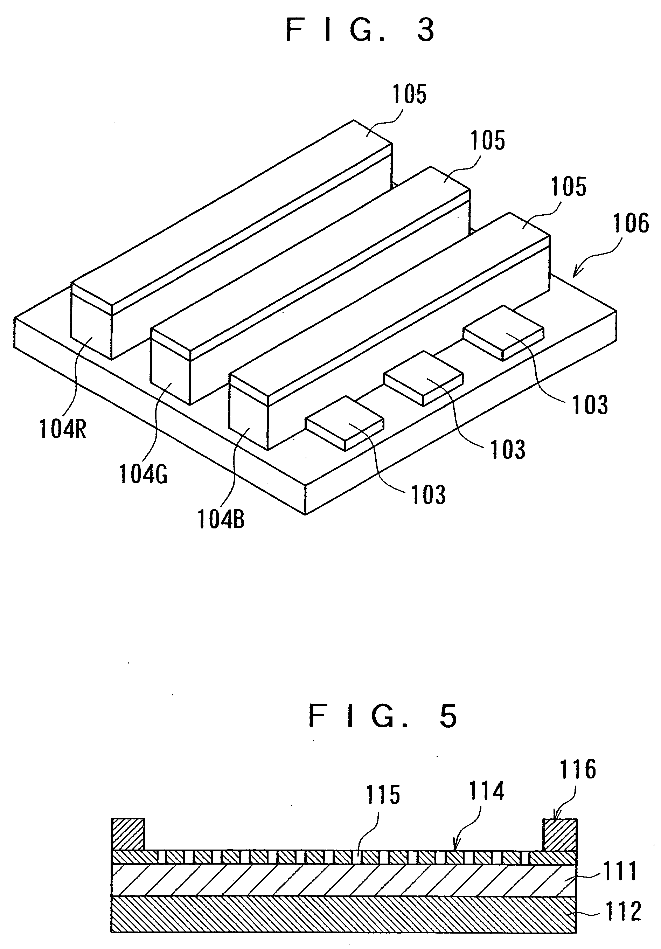

Fig.2 is a plan view showing the subject matter of an organic EL color display configured with such an organic EL device. Fig.3 is a perspective view of a major section of the organic EL color display. In the organic color display 106, the ITO transparent electrodes 103 are formed in a stripe pattern on the transparent substrate 102. Moreover, the organic films 104 are formed in a stripe pattern so that the organic films 104 can be positioned orthogonal to the ITO transparent electrodes 103. The back plate electrode 105 is formed on each of the organic films 104. The ITO transparent electrodes 103, the organic films 104, and the back plate electrodes 105 are arranged in a matrix pattern. Owing to this, the organic film 104 located at the crossing of the ITO transparent electrode 103 and the back plate electrode 105, to which a voltage is applied, emits the light L.

Then, for the organic films 104, a pixel of RGB colors is formed in turn by disposing an organic film 104R which emits the light of red (R) color, an organic film 104G which emits the light of green (G) color, and an organic film 104B which emits the light of blue (B) color. This allows for display of colors.

Now, conventionally, for the purpose of forming an organic film using a low-molecular weight organic matter, a vacuum vapor deposition method has been employed. The vacuum vapor deposition method is a method of forming a thin film by heating and evaporating the raw material under a high vacuum, and then making the raw material absorbed onto the substrate opposing to the vaporizing source.

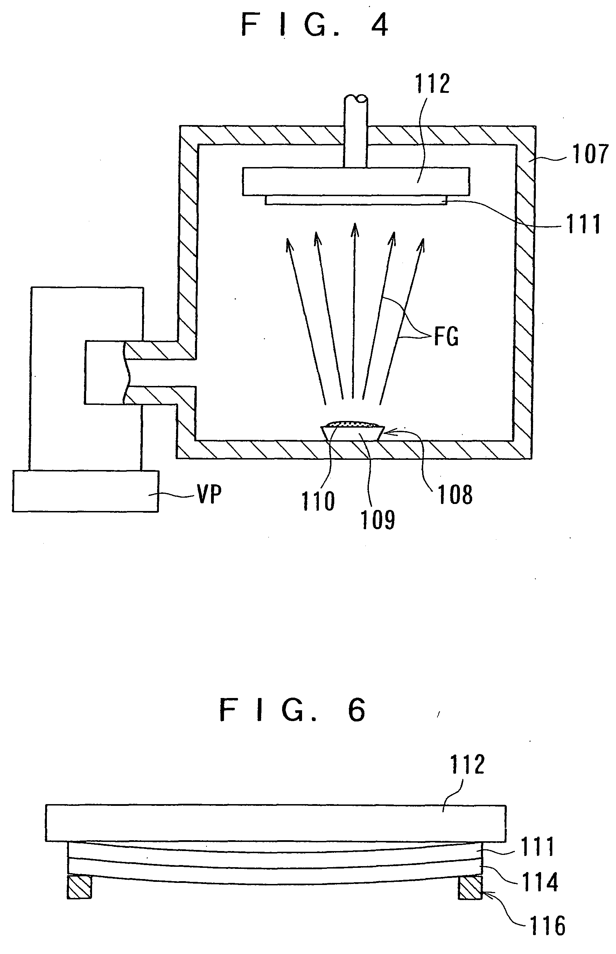

Fig.4 is an illustration showing the basic configuration of a vacuum vapor deposition apparatus for performing such a vacuum vapor deposition method. A chamber 107 is connected to a vacuum pump VP for performing the exhaustion to create a high vacuum within the chamber 107. Herein, the vacuum within the chamber 107 used for the vacuum vapor deposition method ranges in degree from about 10⁻³ Pa (Pascal) to about 10⁻⁴ Pa.

Vaporizing source 108 is a heating source for vaporizing raw material, herein, that is, organic raw material. As a heating method, there are electric resistance heating, electron beam heating, infrared heating, high frequency induction heating and the like. For an organic film, however, the electric resistance heating is generally used. As the electric resistance heating, an organic raw material 110 in a powder state is inputted into an open container 109, which is referred to as a boat. The organic raw material 110 is indirectly heated under the electric resistance exothermic heat of the relevant open container 109 through energizing the open container 109 so that it may be vaporized as flow of gas FG.

A substrate 111 on which an organic film is formed is mounted on a substrate holder 112. The substrate 111 corresponds to the transparent substrate 102 on which the ITO transparent electrode 103 has been formed as shown in Fig.1. The substrate 111 is arranged in opposition to a vaporizing source 108. The substrate holder 112 holds the substrate 111 with the organic film formation surface thereof facing downward in a vertical direction straight up from the ground.

Now, when the organic material 110 is vaporized from the vaporizing source 108 under a high vacuum within the chamber 107, the flow of gas FG relative to the organic raw material reaches to the substrate 111 like a beam. At this time, the distribution of the film is made uniform by rotating the substrate holder 112.

Note that in the case where the color display as shown in Fig.3 is fabricated, the formation of an organic film is formed using a mask for separately painting pixels. Fig.5 is a cross sectional view of the substrate 111 and the substrate holder 112 showing an example of the deposition step for a film using the mask. The mask 114 has a pattern 115 in a stripe shape. In order to mount the mask 114 on the substrate 111, provided is a presser foot member 116 for holding two sides of the mask 114 opposing to each other in the substrate holder 112.

Then, in order to form the organic films of R, G and B, first, the mask 114 is mounted at a predetermined position. The organic film 104R shown in Fig.3 is then formed with shifting the mounting position of the mask 114 by the mounting portion of 1/3 pitch. Next, the organic film 104G is formed with further shifting the mounting position of the mask 114 by the mounting portion of 1/3 pitch. Here, in the vacuum vapor deposition device shown in Fig.4, the mask 114 is mounted downward.

In the vacuum vapor deposition apparatus, film forming is not possible unless the organic film formation surface of the substrate is set to face downward, which causes a problem of limited substrate arrangements. Fig.6 is an illustration showing the conventional problem. In the vacuum vapor deposition apparatus, the substrate 111 is held with the organic film formation surface thereof facing downward so that the center part of the substrate 111 cannot be held. This causes a problem that the deformation occurs in the substrate 111 and the mask 114. This problem becomes significant as the scaling up of the substrate 111 progresses. The vacuum vapor deposition apparatus, however, cannot deal with this problem.

Moreover, when the substrate 111 and the mask 114 are deformed, there arise problems that edge portions of the pattern 115 of the mask 114 are in shadow, and the influence of the shadow effect that the edge of the organic film to be formed is not made sharp becomes large. Furthermore, there also arises another problem that the precision of the pixel becomes worse and the high pixelization is difficult.

### SUMMARY OF THE INVENTION

The present invention has been made in order to solve such problems, and an object of the present invention is to provide an organic film formation apparatus which is capable of forming an organic film excellent in quality.

In order to solve the above-described problems, an organic film formation apparatus according to a first aspect of the present invention comprises a chamber for containing a substrate having a mask for separately painting pixels on its organic film formation surface, and a holder for holding the substrate. The holder is provided in the chamber. The organic film formation apparatus further comprises vaporizer, carrier-gas-introducing device, raw material gas transportation device, discharging device, and exhausting device. The vaporizer vaporizes organic raw material into gas phase to generate raw material gas. The carrier-gas-introducing device introduces carrier gas and mixes the raw material gas and the carrier gas. The raw material gas transportation device transports the raw material gas using the carrier gas. The discharging device discharges the raw material gas transported by the raw material gas transportation device into the chamber. The exhausting device exhausts the chamber.

The substrate is deposited within the chamber with the organic film formation surface of the substrate facing upward in a vertical direction straight up from the ground, the organic film formation surface of the substrate being put in parallel to the vertical direction, or the organic film formation surface of the substrate being slanted relative to the vertical direction. The organic film formation apparatus forms thin film made of an organic matter on a substrate having a mask for separately painting pixels on an organic film formation surface thereof.

Thus, when the film formation is formed, the arrangements of the substrate within the chamber are arrangements each in which the organic film formation surface of the substrate does not face downward in a vertical direction straight up from the ground. As a result thereof, the film can be formed so that the distribution of the film within the substrate and the pixels is made uniform. This allows the deformations of the substrate and the mask for separately painting pixels, which is attached to the substrate, to be suppressed, thereby obtaining an organic film excellent in its quality. Moreover, the shadow effect of the mask for separately painting pixels is reduced, thereby capable of enhancing precision of the pixels. Then, since the countermeasures against the deformation of the substrate and the mask for separately painting pixels can be realized by adjusting the arrangement of the substrate as above, the countermeasures against the deformation of the substrate and the like accompanying with the scaling up of the substrate can be easily performed.

Moreover, an organic film formation apparatus according a second aspect of the present invention comprises a chamber for containing a substrate having a mask for separately painting pixels on its organic film formation surface, and a holder for holding the substrate. The holder is provided in the chamber. The organic film formation apparatus further comprises vaporizer, carrier gas introducing device, raw material gas transportation device, discharging device, and exhausting device. The vaporizer vaporizes organic raw material into gas phase to generate raw material gas. The carrier-gas-introducing device introduces carrier gas and mixes the raw material gas and the carrier gas. The raw material gas transportation device transports the raw material gas using the carrier gas. The discharging device discharges the raw material gas transported by the raw material gas transportation device into the chamber. The exhausting device exhausts the chamber.

The substrate is deposited within the chamber with the organic film formation surface of the substrate facing downward in a vertical direction straight up from the ground, the organic film formation surface of the substrate being put in parallel to the vertical direction, or the organic film formation surface of the substrate being slanted relative to the vertical direction.

Thus, when the film formation is formed, the arrangements of the substrate within the chamber are arrangements each in which the organic film formation surface of the substrate does not face upward in a vertical direction straight up from the ground. This allows adhesion of particles to the substrate and the mask for separately painting pixels, which is mounted on the substrate, to be suppressed, thereby obtaining an organic film excellent in quality.

Furthermore, an organic film formation apparatus according to a third aspect of the present invention comprises a chamber for containing a substrate having a mask for separately painting pixels on an organic film formation surface thereof, and a holder for holding the substrate. The holder is provided in the chamber. The organic film formation apparatus further comprises vaporizer, carrier gas introducing device, raw material gas transportation device, discharging device, and exhausting device. The vaporizer vaporizes organic raw material into gas phase to generate raw material gas. The carrier gas-introducing device introduces carrier gas and mixes the raw material gas and the carrier gas. The raw material gas transportation device transports the raw material gas using the carrier gas. The discharging device discharges the raw material gas transported by the raw material gas transportation device into the chamber. The exhausting device exhausts the chamber.

The substrate is deposited within the chamber with the organic film formation surface of the substrate being put in parallel to a vertical direction straight up from the ground or the organic film formation surface of the substrate being slanted relative to the vertical direction.

Thus, when the film formation is formed, the arrangements of the substrate within the chamber are arrangements each in which the organic film formation surface of the substrate does not face upward or downward in a vertical direction straight up from the ground. This allows the adhesion of particles to the substrate and the mask for separately painting pixels, which is mounted on the substrate, to be suppressed as well as the deformation of the substrate and the mask to be suppressed, thereby obtaining an organic film excellent in quality.

According to the present invention, since the design of an apparatus can be optionally performed due to the important items that are required, such as the countermeasures against the deformation of the substrate and the like, the countermeasures against particles and the like, the reduction of the cost of the apparatus and the miniaturization of the apparatus can be realized.

Then, according to the present invention, an organic EL (electroluminescence) display having a large-scale screen and with less nonuniformity of the luminescence, a high-definition organic EL display and a flexible display can be fabricated. Moreover, an organic EL laser, an organic EL diode and the like can be also fabricated.

### BRIEF DESCRIPTION OF THE DRAWINGS

For a more complete understanding of the present invention and the advantages thereof, reference is now made to the following detailed description taken in conjunction with the accompanying drawings, in which:
Fig.1 is an illustration showing an example of a structure of a conventional organic EL (electroluminescence) device;
Fig.2 is a plan view showing the subject matter of a conventional organic EL color display;
Fig.3 is a perspective view showing the major section of a conventional organic EL display;
Fig.4 is an illustration showing a basic configuration of a conventional vacuum vapor deposition apparatus;
Fig.5 is a cross sectional view showing an example of a process of depositing a film using a mask;
Fig.6 is an illustration showing problems relative to the conventional art;
Fig.7 is a general schematic diagram of an organic film formation apparatus of an embodiment according to the present invention;
Fig.8 is a general schematic diagram showing another embodiment of an organic film formation apparatus according to the present invention;
Fig.9 is a cross sectional view of a chamber showing an example of an arrangement of the substrate according to the present invention;
Fig.10 is a cross sectional view of a chamber showing an example of an arrangement of the substrate considering the suppression of the deformation of the substrate and a mask according to the present invention;
Fig.11 is a cross sectional view of a chamber showing an example of an arrangement of the substrate considering the suppression of the adhesion of particles according to the present invention;
Fig.12 is a cross sectional view of a chamber showing an example of an arrangement of the substrate considering the suppression of the deformation of the substrate and the like and the adhesion of particles according to the present invention;
Figs.13A and 13B are illustrations each showing an example of an arrangement of an injector according to the present invention;
Figs.14A and 14B are cutaway perspective views of a chamber each showing an example of an operation of the substrate according to the present invention; and
Figs. 15A and 15B are cutaway perspective views of a chamber each showing an example of an operation of the substrate according to the present invention.

### DESCRIPTION OF THE PREFERRED EMBODIMENT

Hereinafter, embodiments of an organic film formation apparatus according to the present invention will be described with reference to the drawings.

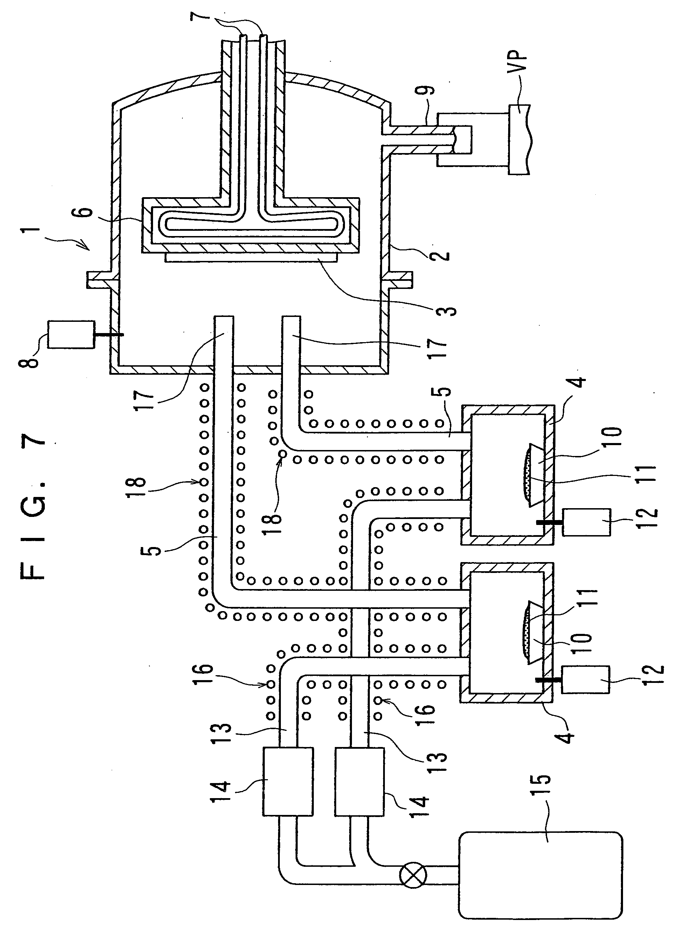

Fig.7 is a general schematic diagram of an organic film formation apparatus of a first embodiment of the present invention. An organic film formation apparatus 1 according to the first embodiment of the present invention has a substrate 3 within a chamber 2 in which a low vacuum is created. The arrangement of substrate 3 is determined considering the various conditions necessary to form an organic film excellent in its quality in a called organic vapor phase deposition method. In the method, an organic film is formed on the substrate 3 by transporting the organic raw material of the gas phase into the chamber 2 using a carrier gas. Herein, the substrate 3 denotes a unit in which an ITO transparent electrode is formed on the transparent glass substrate 102 described in Fig.1 and the like, or a TFT (Thin Film Transistor) substrate, which is not shown, or the like.

The organic film formation apparatus 1 comprises the chamber 2, the vaporizing chambers 4 in each of which an organic raw material is vaporized, and a raw material gas transportation pipe 5 for connecting the vaporizing chamber 4 to the chamber 2. In the chamber 2, a substrate holder 6 as a holding means for holding the substrate 3 is provided. The substrate holder 6 has a mechanism for circulating cooled water, for example, supplied from a cooling pipe 7 as cooling means, and performs the cooling of the substrate 3 that it holds from the back face (face opposite to the organic film formation surface). Herein, the substrate holder 6 has the configuration in which the substrate holder 6 holds the substrate 3 within the chamber 2 with the substrate 3 being put in parallel to a vertical direction straight up from the ground. Note that in the case where light-emitting material used for a color display is prepared, the mask 114 is mounted on the organic film formation surface of the substrate 3 as shown in Fig.5.

For the chamber 2, a pressure gauge 8 and an exhaust pipe 9 are also provided. A vacuum pump VP, which configures the exhaust means, is connected to the exhaust pipe 9. It is controlled so that the pressure within the chamber 2 maintains a predetermined low vacuum through feedback of the output of the pressure gauge 8.

Here, the chamber 2 may have a heater and a thermometer, which are not shown in the drawings, to keep control of the temperature within the chamber 2 at a temperature before the organic raw material has been absorbed on the substrate 3, the temperature at which the organic raw material is not solidified. In order to make the substrate 3 freely input into and output from the chamber 2, for example, the chamber 2 is made to have a divided structure with an opening and closing structure. The air tightness is maintained when the chamber 2 is closed.

Each of the vaporizing chambers 4 constitutes vaporizing means, vaporizes organic raw material by, for example, the electric heating method. The vaporizing chamber 4 has a raw material container 10 in a boat shape in a container capable of isolating the gas from the external air of the chamber or the like. Moreover, the vaporizing chamber 4 is equipped with an energizing mechanism (not shown) which energizes the raw material container 10.

The raw material container 10 is made with a material of, for example, Ta (tantalum) or the like whose melting point is high and which is not reacted with the organic raw material. When the raw material container 10 is energized, this raw material container 10 becomes a resistance and generates heat. Owing to this, when an organic raw material 11 of solid phase (in a powdered state) is inputted into the raw material container 10, the raw material container is energized, the organic raw material 11 is indirectly heated by the raw material container 10 being exothermic, and the raw material is vaporized. Owing to this, the vaporizing chamber 4 which has been completely isolated from the substances for denaturing the organic raw material such as H₂O, O₂ or the like is filled with the organic raw material gas.

For the vaporizing chamber 4, the pressure gauge 12 is provided. When the organic raw material 11 is reduced in the vaporizing chamber 4, the pressure within the vaporizing chamber 4 is lowered. Therefore, the pressure gauge 12 is installed in the vaporizing chamber 4, and the pressure within the vaporizing chamber 4 is measured. Thus, the refilling can be carried out before the organic raw material 11 is depleted by performing the control such that when the lowering of the pressure is detected, the instruction of the refilling of the raw material is directed and so forth.

For the vaporizing chamber 4, in order to control the heating temperature of the organic raw material 11, a thermocouple (not shown) for measuring the temperature of the raw material container 10 is also provided. Moreover, an ampere meter (not also shown) for measuring the value of the current when the raw material container 10 is energized is provided. This allows the temperature of the raw material container 10 and the energized current value to the raw material container 10 to be monitored, thereby controlling the temperature at which the organic raw material 11 is vaporized to be maintained. Moreover, measuring the pressure and the temperature of the vaporizing chamber 4 allows the amount of vaporizing the organic raw material 11 to be controlled so that it can be maintained at a certain level thereof.

Now, in the present embodiment, two independent vaporizing chambers 4 are provided. Supplying pipes 13 are connected to these vaporizing chambers 4, respectively. Each of the supplying pipes 13 has a flow amount controller 14. Moreover, the respective supplying pipes 13 are connected to a tank 15. In the tank 15, gases such as N₂, Ar (Argon) and the like, which are inert to the various organic raw materials, are inputted for the purpose of utilizing them as a carrier gas. Then, the flow amount controller 14 controls the amount of flow of carrier gas to be sent to the vaporizing chamber 4 independently. Thus, the carrier-gas-introducing means is configured with the vaporizing chamber 4 and the mechanism for supplying the carrier gas to the vaporizing chamber 4, which have been described above.

The respective supplying pipes 13 have a heater 16 on the downstream side thereof apart from the flow amount controller 14. Moreover, the respective supplying pipes 13 have the thermometer, which is not shown. Based on the temperature indicated in this thermometer, the heater 16 is controlled so that the temperature of the carrier gas sent from each of the supplying pipes 13 into the vaporizing chamber 4 can be kept at a temperature at which the organic raw material is not solidified.

Each of the raw material gas transportation pipes 5, which configure the raw material gas transportation means, is connected to the respective vaporizing chambers 4. These raw material gas transportation pipes 5 are also connected to the chamber 2. At the end portion within the chamber 2 of each of the raw material gas transportation pipes 5, that is, at the position opposing to the substrate 3, an injector 17 as a discharging means is fixed. The injector 17 has the configuration in which the raw material gas is discharged in a horizontal direction, whereby the incident angle of the raw material gas is determined to be set at 90° with respect to the organic film formation surface of the substrate 3.

Each of the raw material gas transportation pipes 5 has a heater 18 that heats the raw material gas, which is transported using a carrier gas. Moreover, each of the raw material gas transportation pipes 5 has a thermometer, which is not shown. The heater 18 is controlled so that the temperature of the raw material gas transported through the raw material gas transportation pipes 5 can be maintained at a temperature at which the organic raw material is not solidified.

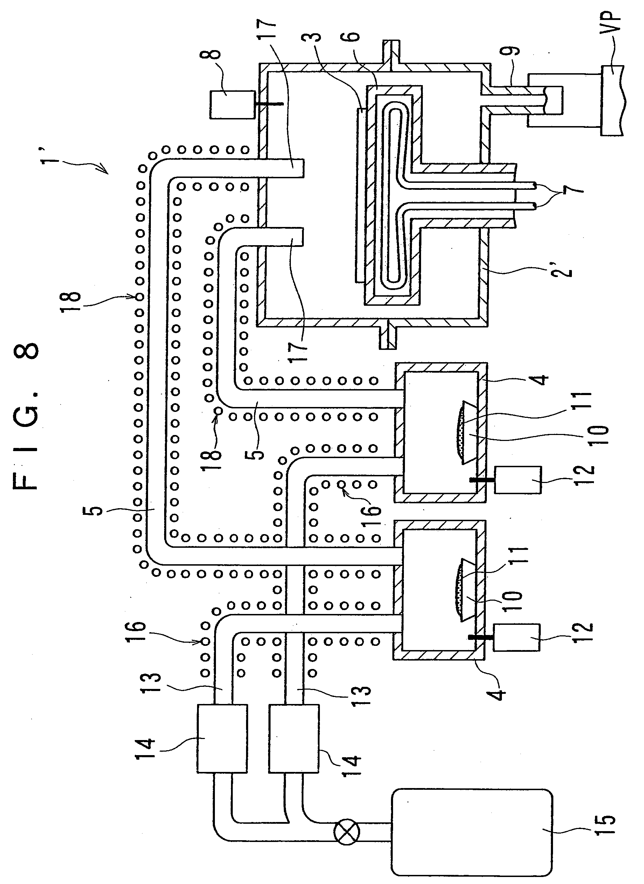

Fig.8 is a general schematic diagram showing an organic film formation apparatus according to another embodiment of the present invention.

An organic film formation apparatus 1' shown in Fig.8 is provided with the substrate holder 6 in a chamber 2'. The substrate holder 6 holds the substrate 3 in a horizontal direction. Owing to this, the organic film formation surface of the substrate 3 faces upward to a vertical direction straight up from the ground. Moreover, as for each of the injectors 17, a discharging outlet of the raw material gas is set downward in the vertical direction straight up from the ground with the injectors 17 facing to the organic film formation surface of the substrate 3.

Moreover, since other remaining components of the general schematic diagram are the same as those of the organic film formation apparatus 1 of Fig.1, the description on the respective components of the configuration is omitted.

Next, the operations of the organic film formation apparatuses of the embodiments of the present invention will be described below.

A method of forming an organic film in the organic gas phase vapor deposition method comprises processes of vaporizing an organic raw material, of introducing the carrier gas, of transporting raw material gas using the carrier gas onto the substrate 3, of depositing an organic film onto the substrate 3, and of exhausting air or gases. Note that since in the organic film formation apparatus 1 shown in Fig.7 and in the organic film formation apparatus 1' shown in Fig.8, similar processes form an organic film, the following explanation will be described with reference to Fig.7.

The process of vaporizing is carried out in the vaporizing chambers 4. In this process of vaporizing, the raw material gas is generated by energizing the raw material container 10 in which the organic raw material 11 is held and by indirectly heating the organic raw material 11 by the resistance exothermic heat of the raw material container 10.

Owing to this, the vaporizing chamber 4 completely isolated from the substances such as H₂O, O₂ and the like, which denatures the organic raw materials, is filled with the raw material gas. Then, in the process of vaporizing, the temperature of the raw material container 10 and the current value energized to the raw material container 10 are monitored, and they are controlled so that the amount of vaporizing of the organic raw material 11 can be maintained at a certain level. Furthermore, the pressure within the vaporizing chamber 4 is monitored by the pressure gauge 12. Then, it is also controlled so that when the lowering of the pressure is detected, the instruction of the refilling of the raw material is directed.

The process of introducing the carrier gas is carried out in the vaporizing chamber 4. In this process of introducing the carrier gas, the introduction of the carrier gas is carried out for diluting and transporting the raw material gas. Specifically, inert gas to the various organic raw materials is sent from the tank 15 into the vaporizing chamber 4 as the carrier gas. The supplying pipes 13 that connect the tank 15 to the respective vaporizing chambers 4 have the flow amount controllers 14, respectively. The carrier gas whose amount of flow is controlled is sent to the vaporizing chamber 4. Then, the carrier gas and the raw material gas thus sent to the vaporizing chamber 4 are mixed, and the raw material gas is sent to each of the raw material gas transportation pipes 5 using a carrier gas.

Now, in the process of introducing the carrier gas, in order to avoid the solidification of the organic raw material due to the lowering of the temperature of the raw material gas within the vaporizing chambers 4, heating the supplying pipe 13 by means of the heater 16 allows the temperature of the carrier gas to be controlled. Moreover, the flow amount controller 14 controls the amount of supplying the carrier gas to be maintained at a constant level. Thus, the amount of the carrier gas to be supplied to the vaporizing chamber 4 is maintained at a constant level and the amount of the organic raw material 11 to be vaporized in the vaporizing chamber 4 is maintained at a constant level. This allows the amount of the raw material sent to the raw material gas transportation pipes 5 to be maintained at a constant level. Owing to this, monitoring the pressure of the vaporizing chambers 4 as described above in the process of vaporizing allows the decrease of the organic raw material 11 to be detected as the lowering of the pressure, thereby performing the refilling of organic raw material 11 before the organic raw material 11 is depleted.

The process of transporting the raw material gas is carried out through the raw material gas transportation pipes 5. In the process of transporting the raw material gas, the raw material gas is transported through the raw material transportation pipes 5 using the carrier gas. Then, the raw material gas thus transported through the raw material gas supplying pipes 5 is discharged from the injector 17 into the chamber 2.

In the process of transporting the raw material gas, if the amount of flow of the carrier gas to be supplied in the above-described process of introducing the carrier gas is increased, the amount of the raw material gas to be transported can be increased. Owing to this, the film formation rate on the substrate 3 is capable of being enhanced. The film formation rate can be largely enhanced comparing to that of the vapor deposition method. Thus, according to the organic gas phase vapor deposition method, the control of film formation rate can be attained under the control of not only the vaporizing temperature of the organic raw material 11, but also the amount of flow of the carrier gas. This allows the precise control of the film formation rate to be realized.

Moreover, in the process of transporting the raw material gas, in order to avoid the solidification of the organic raw material due to the lowering of the temperature of the raw material within the raw material gas transportation pipes 5, the temperature of the raw material gas is controlled by heating the raw material gas transportation pipes 5 by means of the heater 18.

The process of depositing an organic film is carried out in the chamber 2. The raw material gas is transported through the raw material gas transportation pipes 5 in the above-described step of transporting the raw material gas. In the process of depositing the organic film, then, the injector 17 of each of the pipes 5 discharges the raw material gas in the chamber 2 wherein it is absorbed onto the substrate 3, thereby forming an organic film.

Now, note that the temperature of the raw material gas is, for example, about 250°C in order to keep the organic raw material being in the gas phase. Therefore, the temperature of the substrate 3 to which this raw material gas is supplied is increased. Then, in the process of depositing the organic film, flowing cooling water through the cooling pipe 7 into the substrate holder 6 allows the temperature of the substrate 3 to be controlled, thereby maintaining the temperature of the substrate 3 at about room temperature. Moreover, in order to perform the cooling of the substrate 3 efficiently, the substrate holder 6 may be equipped with an electrode (not shown) from which Peltier effect is obtained. According to such a configuration, the cooling pipe 7 allows the heat that this electrode absorbs from the substrate 3 to cool.

Thus, since the formation of an organic film is performed with the temperature of the substrate 3 maintaining around at room temperature, the organic raw material which is absorbed onto the substrate 3 rapidly cools from the state of a gas at a high temperature, thereby forming an organic film having a non-crystal or a fine crystal structure and excellent in quality. Owing to this, the deterioration of the electrical characteristics and the optical characteristics accompanying with the phenomenon that one portion or the entire of the organic film deposited on the substrate 3 is crystallized can be prevented. Moreover, from the fact that the temperature of the substrate 3 is maintained at about room temperature, a plastic substrate, which is weak for heat, is also available for the substrate 3. Hence, in the organic film formation apparatus 1 of the present embodiment of the present invention, it enables to realize that an organic EL (electroluminescence) light-emitting device configuring a flexible display can be fabricated.

The step of exhausting is carried out in the chamber 2. In the step of exhausting, prior to the respective steps described above, the chamber 2 in which the substrate 3 has been contained is maintained at a low vacuum of about 10²-10³ Pa capable of controlling the flow of the raw material gas. Moreover, the residual gas generated in the step of depositing an organic film is exhausted.

As described above, the organic film formation apparatuses 1 and 1' of the present embodiments of the present invention can deposit an organic raw material on the substrate 3 by transporting the organic raw material in the gas phase state within the chamber 2 of a low vacuum using the carrier gas even if the organic film formation surface of the substrate 3 is arranged in parallel to a vertical direction straight up from the ground as shown in Fig.7, or even if the organic film formation surface of the substrate 3 faces upward to the vertical direction as shown in Fig.8.

Specifically, the orientation of the substrate 3 within the chamber 2 and the positional relationship between the substrate 3 and the injector 17 can be determined without limitation due to the gravity. Owing to this, the arrangements of the substrate 3 and the injector 17 within the chamber 2 can be determined considering the various conditions necessary to form an organic film excellent in quality.

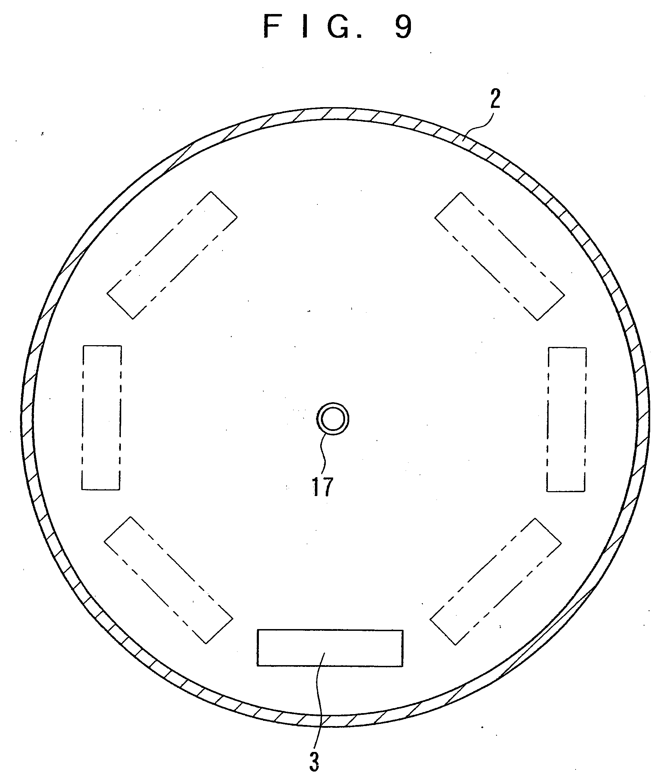

Fig.9 is a cross sectional view of the chamber 2 showing an example of arrangement of the substrate 3.

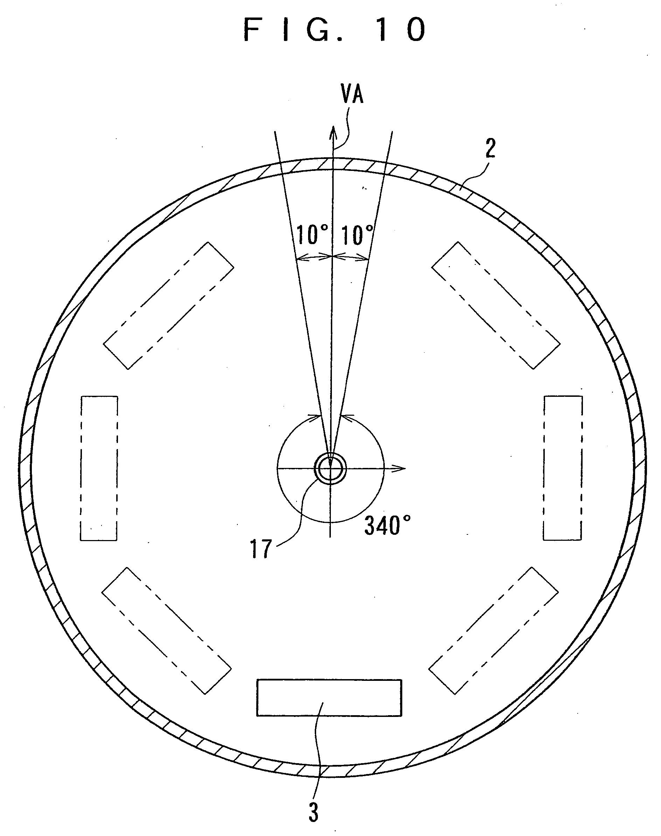

The arrangement of the substrate 3 will be first described below. As an example of the chamber 2, when the substrate 3 is arranged on the circumference whose center places the injector 17 with the organic film formation surface of the substrate 3 facing toward the center, the film formation on the substrate 3 may be realized except for the arrangement in which the organic film formation surface thereof faces downward to the vertical direction straight up from the ground, which is the direction of setting the substrate 3 in the vacuum vapor deposition method. Note that in Fig.9, and in Figs.10 - 12 to be described later, each of the cross sectional shapes of the chambers 2 is made circular. The shape thereof, however, is not limited to this.

Now, when a light-emitting material used for a color display is prepared, the mask 114 shown in Fig.5 is mounted on the organic film formation surface of the substrate 3 in the process of depositing an organic film. The deformation of the mask 114 and the substrate 3 negatively affects the distribution of the film within the surface of the substrate 3 and within the pixels.

As a concrete example of the substrate 3, an example where the arrangement of the substrate 3 mainly is determined considering the suppression of the deformation of the substrate 3 and the like will be described below.

Fig.10 is a cross sectional view of the chamber 2 showing an example of arrangement of the substrate 3 in consideration of suppression of the deformation of the substrate 3 and the mask 114 shown in Fig.5. Considering the suppression of the deformation of the substrate 3 and the like, if the position at which the substrate 3 is arranged on a circumference whose center places the injector 17 is determined, the substrate 3 within the chamber 2 should be arranged in the angle range except for the range of ± 10° of the upper side with respect to the vertical axis VA, that is, in the angle range of the remaining 340°. Where the substrate 3 is set in this range, even if the substrate 3 is slanted, the deformation of the substrate 3 and the mask 114 shown in Fig.5 is suppressed. Even if the size of the substrate 3 is enlarged, this prevents the substrate 3 and the mask 114 from being deformed, thereby making the distribution of the film within the surface of the substrate 3 and within the pixels separately painted uniform. Moreover, since the mask 114 and the substrate 3 are adhered, the reduction of the shadow effect and the precision of the pixels due to the mask 114 are contemplated.

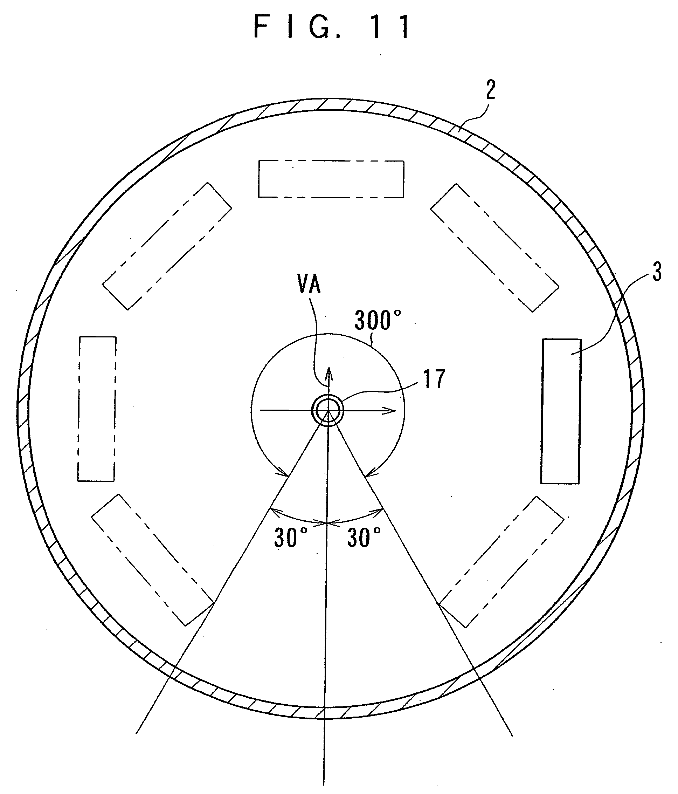

Next, an example where the arrangement of the substrates 3 is determined mainly considering the suppression of the adhesion of particles will be described below. Fig. 11 is a cross sectional view of the chamber 2 showing an example of arrangement of the substrates 3 considering the suppression of the adhesion of particles. Considering the suppression of the adhesion of particles, if the position at which the substrate 3 is arranged is determined on a circumference whose center places the injector 17, the substrate 3 within the chamber 2 is arranged in the range except for the range of ±30° of the lower side with respect to the vertical axis VA, that is, in the range of the remaining 300°. When the substrate 3 is set in this range, particles fall within the chamber 2 without adhering to the substrate 3. These particles can be exhausted externally from, for example, the exhaust pipe 9, which is shown in Fig.7. Owing to this, the failures of having a short circuit, dark spots and the like are reduced and the cost reduction can be realized by enhancing the yield.

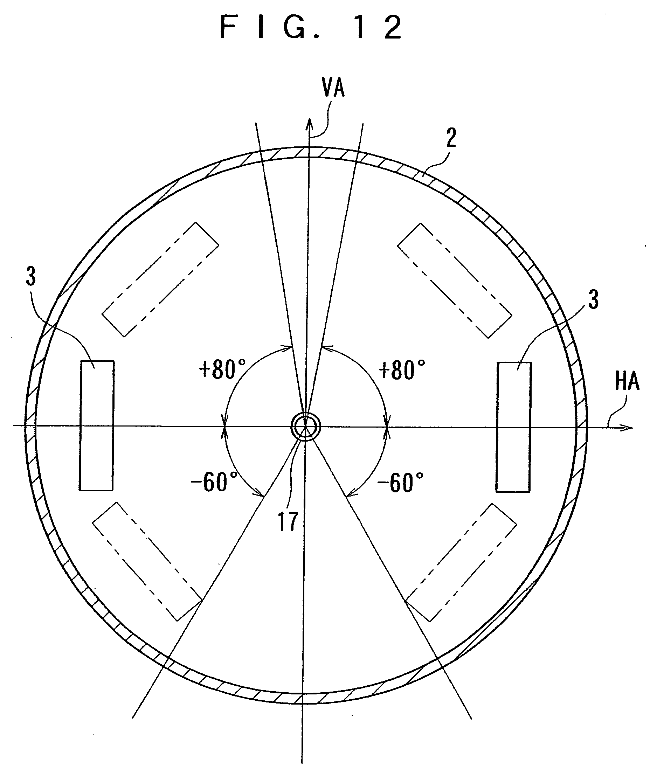

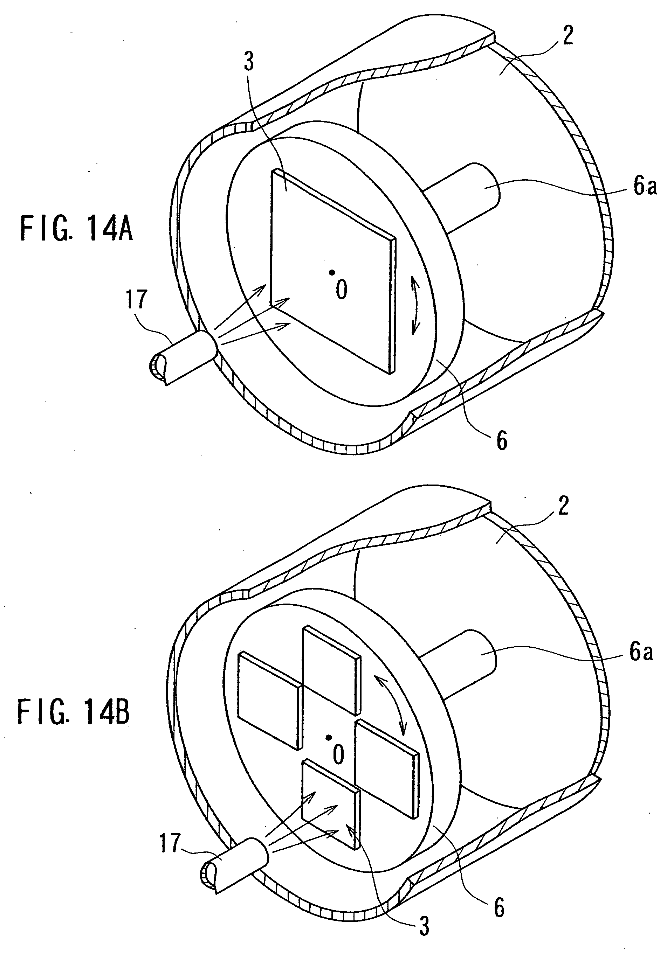

Next, an example where the arrangements of the substrates 3 are determined considering both of the suppression of the deformation of the substrates 3 and the like and the suppression of the adhesion of particles will be described below. Fig. 12 is a cross sectional view of the chamber 2 showing an example of the arrangement of the substrates 3 considering the suppression of the deformation of the substrates 3 and the like and the adhesion of particles. Considering both of the countermeasures against the deformation of the substrate 3 and the like and the countermeasures against the adhesion of particles, if the position at which the substrates 3 are arranged on the circumference whose center places the injector 17 is determined, the respective substrates 3 within the chamber 2 are arranged in the range from +80° to -60° with respect to the horizontal axis HA. When the substrates 3 are set in this range, particles fall without adhering to the substrates 3, and the deformation of the substrates 3 and the masks 114 shown in Fig. 14 is suppressed.

Owing to this, the failures such as a short circuit caused by pixels involving in each other, dark spots and the like are reduced. Even if the size of each of the substrates 3 is scaled up, the deformation of the substrates 3 and the like is suppressed. The distribution of the film within the surface of each of the substrates 3 and within the pixels separately painted can be made uniform. Moreover, the reduction of the shadow effect and the precision of the pixels due to the mask 114 shown in Fig.5 are contemplated.

As described above, devising the arrangement of the substrate(s) 3 allows the quality of the formed organic film to be enhanced, thereby enhancing the yield thereof. As a result of this, the cost reduction can be realized.

Note that the organic film formation apparatus 1 shown in Fig.7 is an example of an arrangement of the substrates shown in Fig.12, and the organic film formation apparatus 1' shown in Fig.8 is an example of the arrangement of the substrate shown in Fig.10. Moreover, it may be a configuration in which multiple substrates 3 are held within the chamber 2. For example, as shown in Fig. 12, two sheets of substrates 3 are held with the organic film formation surfaces of each of the substrates 3 being put in parallel to a vertical direction straight up from the ground and arranged in opposing positions from each other across the injector 17. If so, the same film may be formed on the two sheets of the substrates 3 at the same time under the same conditions.

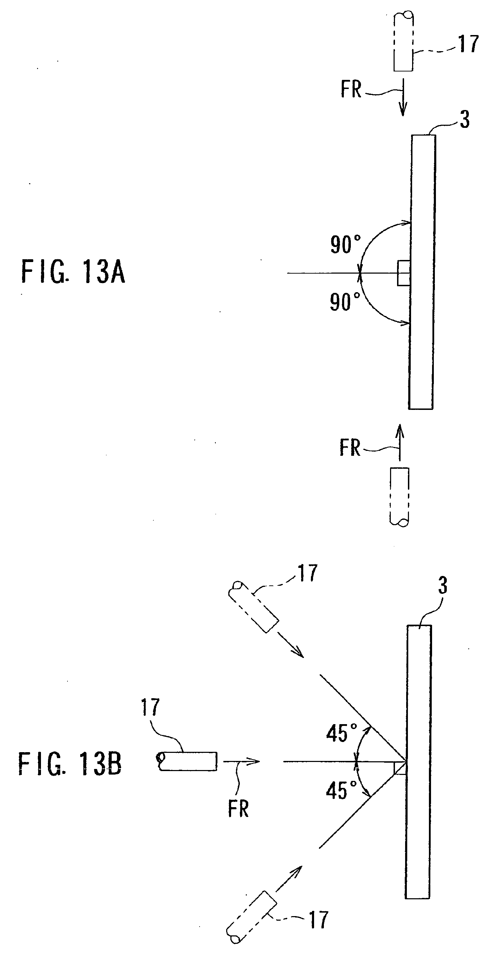

Figs.13A and 13B are illustrations each showing an example of the arrangement of the injector 17. The arrangement of the injector 17 will be described below.

If the injector 17 is arranged so that the injector 17 varies in orientation with respect to the substrate 3 within the range of ±90° with respect to an axis orthogonal to the organic film formation surface of the substrate 3, as shown in Fig. 13A, that is, the raw material gas is blasted from the horizontal direction with respect to the organic film formation surface, the organic raw material can be deposited on the substrate 3.

Desirably, as indicated in Fig. 13B by a line with two short-dashed parts, the injector 17 may be arranged with the raw material gas being blasted from the angles within the range of ±45° with respect to the axis orthogonal to the organic film formation surface of the substrate 3.

Furthermore, as shown by a solid line in Fig.13B, the injector 17 may be arranged opposingly to the substrate 3 so that the raw material gas is blasted from the direction orthogonal to the organic film formation surface of the substrate 3. Specifically, as shown in Figs.7 and 8, if the substrate 3 and the injector 17 are arranged opposing to each other, the raw material gas can be efficiently supplied onto the substrate 3.

The distribution of the film becomes more uniform by forming the film on the substrate 3 with the substrate 3 rotating, for example, rather than by forming the film on the substrate 3 with the substrate 3 being fixed with respect to the injector 17. Therefore, a mechanism for driving the substrate holder 6 may be equipped in the organic film formation apparatus 1 of Fig.7 and the like.

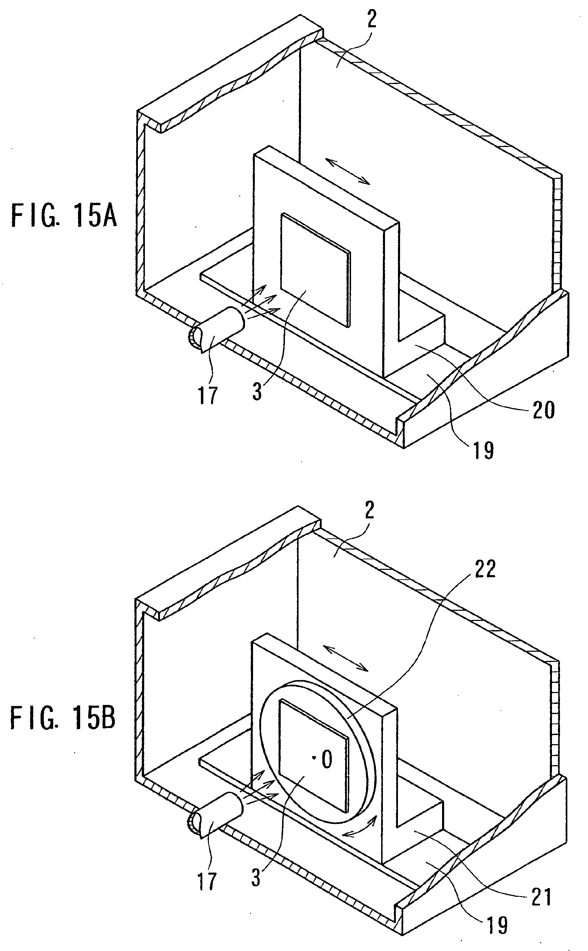

Figs.14A, 14B, 15A, and 15B are cutaway perspective views of the chamber 2 each showing the operational example of the substrate 3. In a configuration shown in Fig.14A, the substrate holder 6 has a rotation mechanism driven by drive means (not shown) for rotating it about a center of an axis 6a, and is equipped with a mechanism for holding the substrate 3 so that a center of the substrate 3 corresponds to the rotation center O of the substrate holder 6. Here, the center of the substrate 3 indicates a point of intersection of the diagonal lines in the substrate 3. Thus, when the drive means (not shown) rotates the substrate holder 6, the substrate 3 rotates about the rotation center O of the substrate holder 6.

Since the raw material gas discharged from the injector 17 is diffused and supplied onto the substrate 3, the distribution of the film of the organic film formed on the substrate 3 becomes uniform by forming the film with the substrate 3 rotating.

In a configuration shown in Fig. 14B, the substrate holder 6 has a rotation mechanism driven by drive means (not shown) for rotating it about a center of the axis 6a, and has a mechanism for holding multiple substrates 3 on the same circumference around the rotation center O of the the substrate holder 6. When the drive means (not shown) rotates the substrate holder 6, the respective substrates 3 move around the rotation center O of the substrate holder 6.

Then, the raw material gas discharged from the injector 17 is diffused and supplied onto the substrate 3 that is positioned in front of the injector 17. Since the respective substrates 3 revolve around the rotation center O of the substrate holder 6, all of the substrates 3 sequentially pass through the position in front of the injector 17, and at this position, the raw material gas is supplied to the respective substrates 3. In this way, since the organic films can be formed on multiple substrates 3 by once performing the process of depositing the organic film, the many substrates 3 in a small size can be produced.

In a configuration shown in Fig.15A, a substrate holder 20 that is slid by the drive mechanism 19 utilizing a linear motor and the like is provided within the chamber 2. Then, the injector 17 is provided at a position where it is opposed to the substrate 3 held in the substrate holder 20. In the above-described configuration, during the step of depositing the organic film, the injector 17 discharges the raw material gas with the substrate holder 20 being slid. According to the configuration, supplying the raw material gas on the entire surface of the substrate 3 allows the organic raw material to be deposited. Therefore, the distribution of the film within the surface of the substrate 3 and within the pixels is made uniform.

In a configuration shown in Fig.15B, a substrate holder 21 that is slid by the drive mechanism 19 utilizing a linear motor and the like within the chamber 2 is provided. In this substrate holder 21, a sub-holder 22 for rotating the substrate 3 driven by drive means (not shown) is provided. The sub-holder 22 has a mechanism for holding the substrate 3 with the center of the substrate 3 corresponding to the rotation center O of the sub-holder 22. When the drive means (not shown) rotates the sub-holder 22, the substrate 3 rotates about the rotation center O of the sub-holder 22. Then, sliding the whole of the substrate holder 21 by means of the drive mechanism 19 allows the substrate 3 to be slid with rotating.

In the above-described configuration, during the process of depositing the organic film, the injector 17 discharges the raw material gas while the whole of the substrate holder 21 is slid with the sub-holder 22 rotating. According to the configuration, supplying the raw material gas on the entire surface of the substrate 3 allows the organic raw material to be deposited. Therefore, the distribution of the film within the surface of the substrate 3 and within the pixels is made uniform. Note that in the configuration of Fig. 15B, the substrates 3 could be arranged as shown in Fig.14B to be revolved.

As described above, sliding the substrate 3 with respect to the injector 17, rotating the substrate 3, or performing the movements in which both are combined allows the uniformity of the distribution of the film within the surface of the substrate 3 and within the pixels to be enhanced. Moreover, when the substrate 3 is operated, providing a mechanism for cooling the substrate 3 as shown in Fig.7 allows more excellent organic film to be fabricated.

Thus, determining the arrangements of the substrate 3 and the injector 17, the movement of the substrate 3 and the like according to the various conditions for forming an excellent organic film allows the productivity to be enhanced, and the enhancement of the yield / cost reduction to be realized.

According to the embodiments of the invention, the arrangements of the substrate 3 and the injector 17, the movement of the substrate 3 and the like can be determined corresponding to the problems such as the tendency of the distribution of the film, and the shadow effect of the mask for separately painting pixels. This causes designing of the apparatus configuration to be facilitated and less restricted. Furthermore, the reduction of the cost of the apparatus and the miniaturization of the apparatus can be realized.

It will also be appreciated that, although a limited number embodiments of the invention have been described in detail for purposes of the illustration, various modifications may be made without departing from the spirit and scope of the invention. Accordingly, the invention should not be limited except as by the appended claims.

## Claims

1. An organic film formation apparatus for forming thin film made of an organic matter on a substrate having a mask for separately painting pixels on an organic film formation surface thereof, said organic film formation apparatus comprising:
a chamber for containing said substrate;
holding means for holding said substrate, said holding means being provided in said chamber,
vaporizing means for vaporizing organic raw material into gas phase to generate raw material gas;
carrier-gas-introducing means for introducing carrier gas and mixing said raw material gas and said carrier gas;
raw material gas transportation means for transporting said raw material gas using said carrier gas;
discharging means for discharging said raw material gas transported by said raw material gas transportation means into said chamber, and
exhausting means for exhausting said chamber,
wherein said substrate is deposited within said chamber with said substrate being set in an arrangement selected from an arrangement in which said organic film formation surface of said substrate faces upward in a vertical direction straight up from the ground, an arrangement in which said organic film formation surface of said substrate is put in parallel to the vertical direction, and an arrangement in which said organic film formation surface of said substrate is slanted relative to the vertical direction.

2. The organic film formation apparatus as claimed in Claim 1, wherein within said chamber, said substrate is set in an arrangement selected from arrangements along a circumference whose center places said discharging means except for a range in angles of ±10° of upper side with respect to the vertical direction.

3. The organic film formation apparatus as claimed in Claim 1, wherein said discharging means discharges the raw material gas within a range in angles of ±90° with respect to a direction orthogonal to said organic film formation surface of said substrate.

4. The organic film formation apparatus as claimed in Claim 1, wherein said discharging means discharges the raw material gas within a range in angles of ±45° with respect to a direction orthogonal to said organic film formation surface of said substrate.

5. The organic film formation apparatus as claimed in Claim 1, wherein said discharging means discharges the raw material gas in a direction orthogonal to said organic film formation surface of said substrate.

6. The organic film formation apparatus as claimed in Claim 1, wherein said holding means slides said substrate having said mask for separately painting pixels.

7. The organic film formation apparatus as claimed in Claim 1, wherein said holding means turns said substrate having said mask for separately painting pixels.

8. The organic film formation apparatus as claimed in Claim 1, wherein said holding means turns to allow said substrate having said mask for separately painting pixels to move around an axis of said holding means.

9. The organic film formation apparatus as claimed in Claim 1, wherein said holding means turns said substrate having said mask for separately painting pixels while sliding said substrate.

10. The organic film formation apparatus as claimed in Claim 1, wherein said holding means includes cooling means for cooling a back face of said substrate having said mask for separately painting pixels.

11. An organic film formation apparatus for forming thin film made of an organic matter on a substrate having a mask for separately painting pixels on an organic film formation surface thereof, said organic film formation apparatus comprising:
a chamber for containing said substrate;
holding means for holding said substrate, said holding means being provided in said chamber;
vaporizing means for vaporizing organic raw material into gas phase to generate raw material gas;
carrier gas introducing means for introducing carrier gas and mixing said raw material gas and said carrier gas;
raw material gas transportation means for transporting said raw material gas using said carrier gas;
discharging means for discharging said raw material gas transported by said raw material gas transportation means into said chamber; and
exhausting means for exhausting said chamber,
wherein said substrate is deposited within said chamber with said substrate being set in an arrangement selected from an arrangement in which said organic film formation surface of said substrate faces downward in a vertical direction straight up from the ground, an arrangement in which said organic film formation surface of said substrate is put in parallel to the vertical direction, and an arrangement in which said organic film formation surface of said substrate is slanted relative to the vertical direction.

12. The organic film formation apparatus as claimed in Claim 11, wherein within said chamber, said substrate is set in an arrangement selected from arrangements along a circumference whose center places said discharging means except for a range in angles of ±30° of lower side with respect to the vertical direction.

13. The organic film formation apparatus as claimed in Claim 11, wherein said discharging means discharges the raw material gas within a range in angles of ±90° with respect to a direction orthogonal to said organic film formation surface of said substrate.

14. The organic film formation apparatus as claimed in Claim 11, wherein said discharging means discharges the raw material gas within a range in angles of ±45° with respect to a direction orthogonal to said organic film formation surface of said substrate.

15. The organic film formation apparatus as claimed in Claim 11, wherein said discharging means discharges the raw material gas in a direction orthogonal to said organic film formation surface of said substrate.

16. The organic film formation apparatus as claimed in Claim 11, wherein said holding means slides said substrate having said mask for separately painting pixels.

17. The organic film formation apparatus as claimed in Claim 11, wherein said holding means turns said substrate having said mask for separately painting pixels.

18. The organic film formation apparatus as claimed in Claim 11, wherein said holding means turns to allow said substrate having said mask for separately painting pixels to move around an axis of said holding means.

19. The organic film formation apparatus as claimed in Claim 11, wherein said holding means turns said substrate having said mask for separately painting pixels while sliding said substrate.

20. The organic film formation apparatus as claimed in Claim 11, wherein said holding means includes cooling means for cooling a back face of said substrate having said mask for separately painting pixels.

21. An organic film formation apparatus for forming thin film made of an organic matter on a substrate having a mask for separately painting pixels on an organic film formation surface thereof, said organic film formation apparatus comprising:
a chamber for containing said substrate;
holding means for holding said substrate, said holding means being provided in said chamber,
vaporizing means for vaporizing organic raw material into gas phase to generate raw material gas;
carrier gas introducing means for introducing carrier gas and mixing said raw material gas and said carrier gas;
raw material gas transportation means for transporting said raw material gas using said carrier gas;
discharging means for discharging said raw material gas transported by said raw material gas transportation means into said chamber; and
exhausting means for exhausting said chamber,
wherein said substrate is deposited within said chamber with said substrate being set in an arrangement selected from an arrangement in which said organic film formation surface of said substrate is put in parallel to a vertical direction straight up from the ground and an arrangement in which said organic film formation surface of said substrate is slanted relative to the vertical axis.

22. The organic film formation apparatus as claimed in Claim 21, wherein within said chamber, said substrate is set in an arrangement selected from arrangements along a circumference whose center places said discharging means within a range in angles from +80° to -60° with respect to a horizontal axis of said chamber at both opposite sides along the vertical axis of said chamber.

23. The organic film formation apparatus as claimed in Claim 21, wherein said discharging means discharges the raw material gas within a range in angles of ±90° with respect to a direction orthogonal to said organic film formation surface of said substrate.

24. The organic film formation apparatus as claimed in Claim 21, wherein said discharging means discharges the raw material gas within a range in angles of ±45° with respect to a direction orthogonal to said organic film formation surface of said substrate.

25. The organic film formation apparatus as claimed in Claim 21, wherein said discharging means discharges the raw material gas in a direction orthogonal to said organic film formation surface of said substrate.

26. The organic film formation apparatus as claimed in Claim 21, wherein said holding means slides said substrate having said mask for separately painting pixels.

27. The organic film formation apparatus as claimed in Claim 21, wherein said holding means turns said substrate having said mask for separately painting pixels.

28. The organic film formation apparatus as claimed in Claim 21, wherein said holding means turns to allow said substrate having said mask for separately painting pixels to move around an axis of said holding means.

29. The organic film formation apparatus as claimed in Claim 21, wherein said holding means turns said substrate having said mask for separately painting pixels while sliding said substrate.

30. The organic film formation apparatus as claimed in Claim 21, wherein said holding means includes cooling means for cooling a back face of said substrate having said mask for separately painting pixels.
